# EUROPEAN PATENT SPECIFICATION

(11) **EP 4 437 271 B1**
(45) Date of publication and mention of the grant of the patent: **14.10.2026**
(21) Application number: 22899274.9
(22) Date of filing: 08.11.2022
(51) Int. Cl.: G09F 9/33

(54) **DISPLAY ASSEMBLY WITH DIVIDED INTERIOR SPACE**
ANZEIGEANORDNUNG MIT UNTERTEILTEM INNENRAUM
ENSEMBLE D'AFFICHAGE À ESPACE INTÉRIEUR DIVISÉ

(30) Priority: 23.11.2021 US 202117533609
(43) Date of publication of application: 02.10.2024
(73) Proprietor: Manufacturing Resources International, Inc., Alpharetta, GA 30005 (US)
(72) Inventor: DUNN, William, Alpharetta, GA 30005 (US); DIAZ, Marcos, Alpharetta, GA 30005 (US); MOREAU, Alex, Alpharetta, GA 30005 (US)
(74) Representative: FRKelly
(86) International application number: PCT/US2022/049263
(87) International publication number: WO 2023/096738

(56) References cited:
- US-A1- 2009 310 065
- US-A1- 2014 313 698
- US-A1- 2019 208 674
- US-A1- 2019 327 865
- US-A1- 2020 390 009

## Description

### CROSS-REFERENCE TO RELATED APPLICATIONS

### TECHNICAL FIELD

Exemplary embodiments relate generally to display assemblies with divided interior space, such as for increased cooling, and systems and methods for operating such display assemblies.

### BACKGROUND AND SUMMARY OF THE INVENTION

Display assemblies often generate heat, such as from solar loading, ingestion of relatively warm ambient air, and/or powering of internal components such as a backlight. This results in a need to thermally manage such display assemblies, particularly when used in outdoor applications. It is known to provide back-to-back electronic displays with a common plenum, such as is provided in US Pat. No. 8,373,841 issued February 12, 2013, or a common heat exchanger, such as is provided in US Pat. No. 8,351,014 issued January 8, 2013. As energy and/or manufacturing efficiency demands increase, what is needed are display assemblies which provide efficient thermal management and/or which are capable of being manufactured in an efficient manner.

Display assemblies which are capable of being manufactured in an efficient manner and/or which provide efficient thermal management are provided. These display assemblies include multiple electronic display subassemblies (hereinafter also "subassemblies"). Each of the multiple electronic display subassemblies are mountable to a structural framework, such as so they face in substantially opposing directions. The subassemblies may be completely or substantially identical to reduce manufacturing complexity and/or the need to store or provide different types of subassemblies, such as for servicing or replacement, in exemplary embodiments.

Each of the subassemblies, in exemplary embodiments, comprises a front passageway located between a rear surface of a cover and a front surface of an electronic display layer, an illumination device cavity located between a rear surface of the electronic display layer and a front surface of an illumination device, an open loop channel located between the rear surface of the illumination device and a front surface of a rear cover, a corrugated layer located within the open loop channel, one or more electronic components mounted to a rear surface of the rear cover, and/or one or more fans mounted to the rear surface of the rear cover, to name some non-limiting examples.

A common passageway is provided between the subassemblies.
The common passageway may be defined, at least in part, by rear surfaces of the subassemblies and inner surfaces of the structural framework in exemplary embodiments. A central septum extends between rear surfaces of the subassemblies and within the common passageway. The central septum may extend at, or proximate to, a midline of the common passageway so as to divide the common passageway into approximately first and second halves though the central septum may be placed elsewhere. In this manner, crossover between circulating gas in the closed loop exiting a first one of the subassemblies and exiting a second one of the subassemblies may be at least substantially prevented within the common passageway. The central septum may serve to divide the common passageway into multiple portions. At least part of the central septum may extend at an angle relative to the rear surfaces of the subassemblies and/or inner surfaces of the structural framework to improve aerodynamics.

A side septum may extend within each portion of the common passageway, such as between an exit of a respective one of the subassemblies and an entrance to an opposing one of the subassemblies. The side septa may act as baffles. The side septa may force circulating gas to take a sinuous path between the subassemblies, increasing surface area and time for cooling. However, the central septum may substantially prevent such circulating gas from prematurely crossing over to another portion of the common passageway.

Heat exchangers may be provided within a space between a respective one of the side assemblies and the respective one of the side septa. In this manner, circulating gas exiting the respective one of the side assemblies, which may be relatively hot such as from solar loading for example, may be cooled by ambient air passing through the respective one of the heat exchangers.

Closed loop fans may each be provided at rear surfaces of the subassemblies, such as adjacent to an entrance to the front passageways of the side assemblies. The closed loop fans may be configured to force circulating gas through the various airflow passageways, such as part of a closed loop, when activated.

The side septa, central septum, closed loop fans, and/or heat exchangers may be mounted to the rear surfaces of the rear covers in exemplary embodiments. In other exemplary embodiments, one or more of the side septa, central septum, and/or heat exchangers may be mounted to the structural framework.

In the case of units having multiple subassemblies, such as two subassemblies positioned to face in substantially opposing directions, one of the two subassemblies may face the sun more directly at certain times, and thus pick up more heat. The second one of the subassemblies may not be as directly exposed to the sun at such times because it faces in substantially the opposite direction. Thus, passing circulating gas through the second one of the subassemblies may help to cool circulating gas heated when passed the first one of the subassemblies. In this manner, the second one of the subassemblies may act as a heat exchanger for the first one of the subassemblies.

Gas springs, or other movement facilitating and/or assisting devices may be located within the common passageway for moving the subassemblies between an opened position whereby the subassemblies extend away from the structural framework and at least a portion of the common passageway may be accessed, and a closed position, whereby the subassemblies are positioned adjacent to the structural framework and the common passageway is fully or partially sealed.

Further features and advantages of the systems and methods disclosed herein, as well as the structure and operation of various aspects of the present disclosure, are described in detail below with reference to the accompanying figures.

### BRIEF DESCRIPTION OF THE DRAWINGS

In addition to the features mentioned above, other aspects of the present invention will be readily apparent from the following descriptions of the drawings and exemplary embodiments, wherein like reference numerals across the several views refer to identical or equivalent features, and wherein:
**FIGURE 1** is a perspective view of an exemplary display assembly in accordance with the present invention also indicating section lines A-A and B-B;
**FIGURE 2** is a top section view take along section line A-A of figure 1;
**FIGURE 3** is a rear perspective view of one subassembly of figure 1 shown in isolation;
**FIGURE 4A** is the top sectional view of figure 2 further illustrating exemplary airflow velocities;
**FIGURE 4B** is the top sectional view of figure 2 further illustrating exemplary airflow temperatures;
**FIGURE 5** is a detailed rear view of the display assembly of figure 1 with one of the subassemblies removed;
**FIGURE 6** is a rear view of the subassembly of figure 3;
**FIGURE 7** is the detailed rear view of figure 5 further illustrating exemplary airflow velocities;
**FIGURE 8A** is the rear view of the subassembly of figure 6 further illustrating exemplary airflow velocities;
**FIGURE 8B** is the rear view of the subassembly of figure 6 further illustrating exemplary airflow temperatures; and
**FIGURE 9** is a side sectional view taken along section line B-B of figure 1 further illustrating exemplary airflow velocities.

### DETAILED DESCRIPTION OF EXEMPLARY EMBODIMENT(S)

Various embodiments of the present invention will now be described in detail with reference to the accompanying drawings. In the following description, specific details such as detailed configuration and components are merely provided to assist the overall understanding of these embodiments of the present invention. Therefore, it should be apparent to those skilled in the art that various changes and modifications of the embodiments described herein can be made without departing from the scope and spirit of the present invention. In addition, descriptions of well-known functions and constructions are omitted for clarity and conciseness.

Embodiments of the invention are described herein with reference to illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.

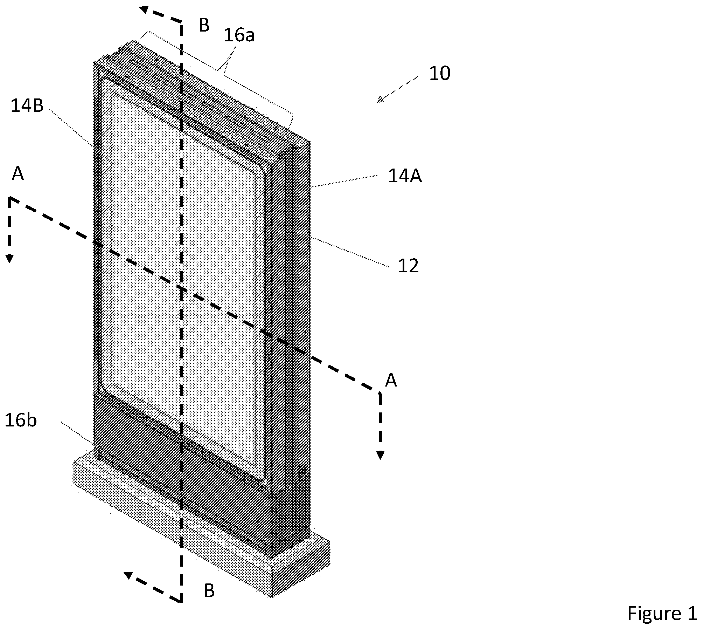

**FIGURE 1** is a perspective view of an exemplary electronic display assembly (hereinafter also a "unit") 10 in accordance with the present invention. The unit 10 may include a structural framework 12. The structural framework 12 may be configured for mounting to a ground surface, such as a sidewalk or street, mounting to a wall or other surface, incorporation into street furniture (e.g., phone booths, bus shelters, benches, railings, combinations thereof, or the like), combinations thereof, or the like. The structural framework 12 may comprise one or more members, panels, cladding, housings, combinations thereof, or the like. The structural framework 12 may comprise multiple components joined together.

The units 10 may comprise one or more electronic display subassemblies 14. Some or all of the electronic display subassemblies 14 may be attached to the structural framework 12 in a moveable manner, though such is not required. For example, the electronic display subassemblies 14 may be attached to the structural framework 12 in a hinged or otherwise moveable manner to permit selective movement between a closed position whereby certain parts of the units 10 are fully or partially sealed, and an open position whereby certain parts of the interior of the unit 10 are exposed for access. In exemplary embodiments, the units 10 may comprise a first and second electronic display subassemblies 14a, 14b placed on either side of the structural framework 12 such that the electronic display subassemblies 14a, 14b face in substantially opposing directions, for example.

One or more external openings 16 may be provided at the units 10 for ingesting and/or exhausting ambient air. In exemplary embodiments, a series of such openings 16a may be provided along an upper portion of the structural assembly 12, such as between the subassemblies 14, and may serve as intakes. In exemplary embodiments, another series of such openings 16b may be provided along a lower portion of the structural assembly 12 and may serve as exhausts. In exemplary embodiments, a set of one or more opening for exhausting air 16b may be provided below each of the subassemblies 14, and/or a single set of openings for ingesting air 16a may be common to some or all of the subassemblies 14. The openings 16 may be fully or partially covered with a screen, mesh, dust filter, vent, combination thereof, or the like.

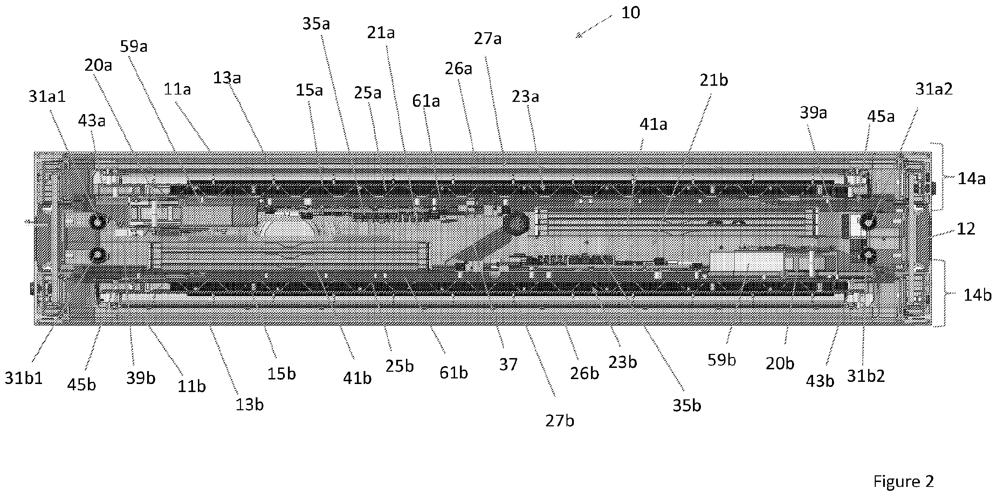

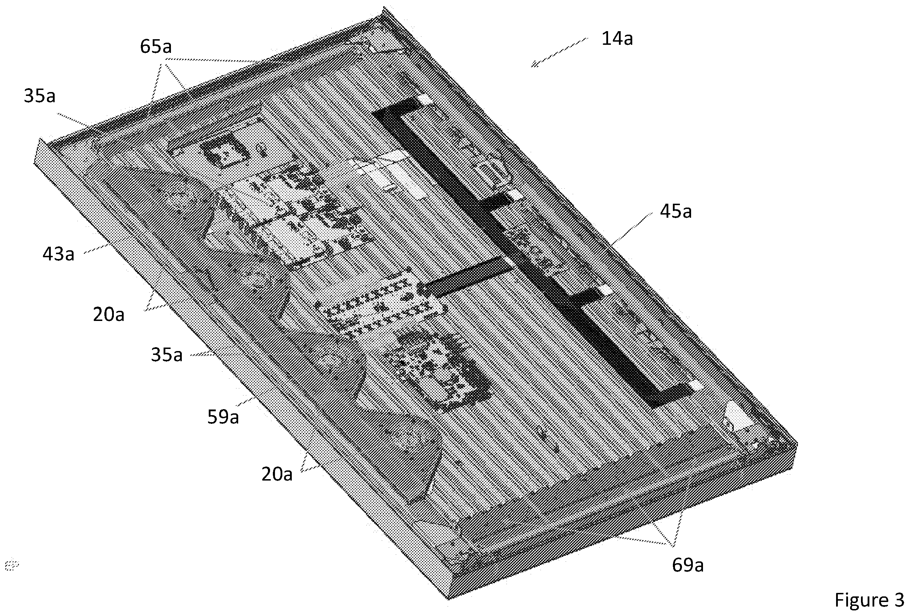

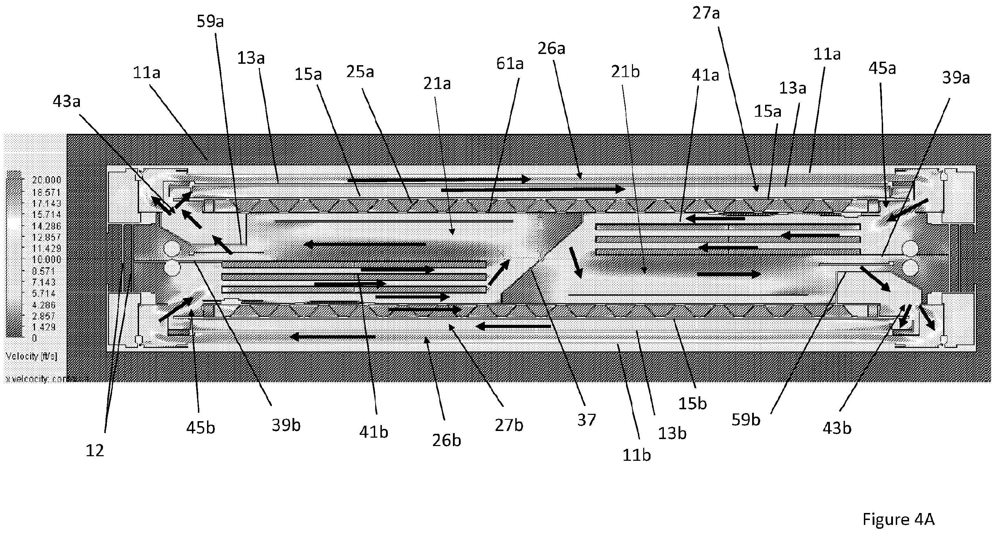

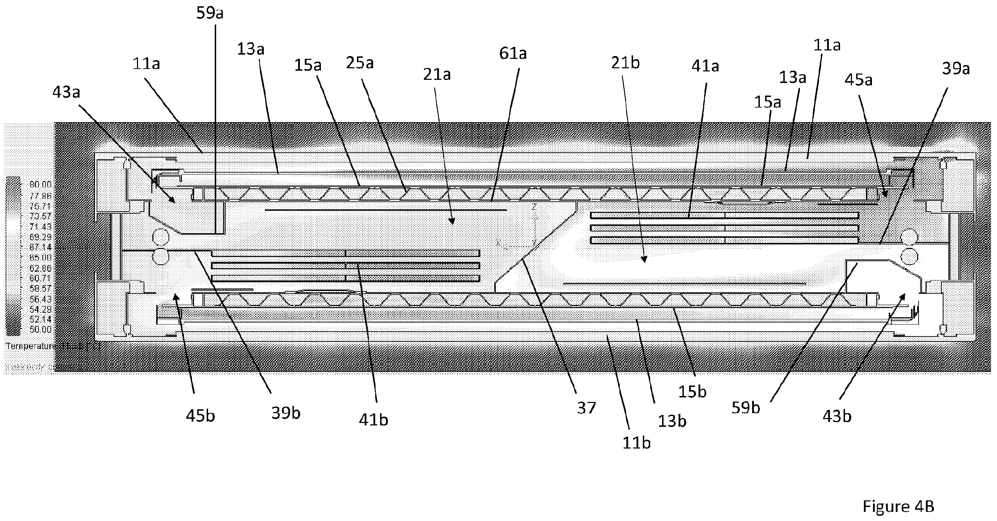

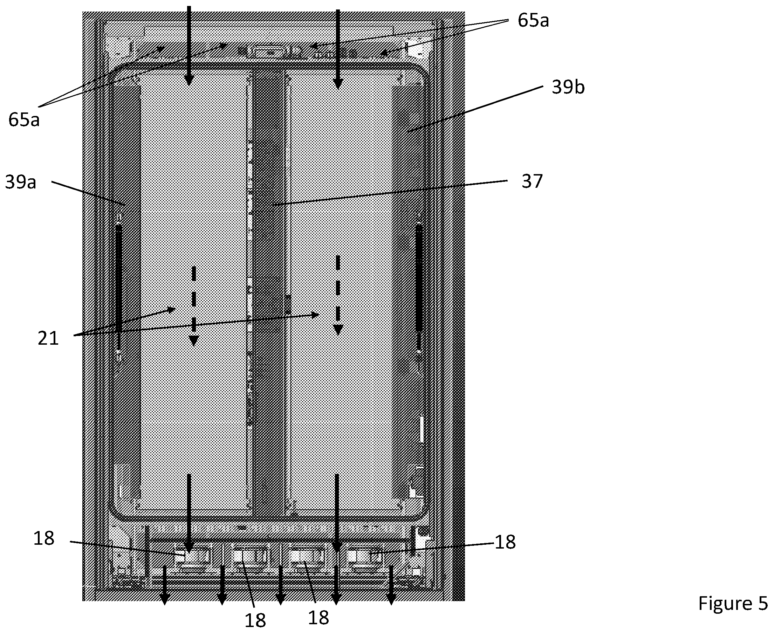

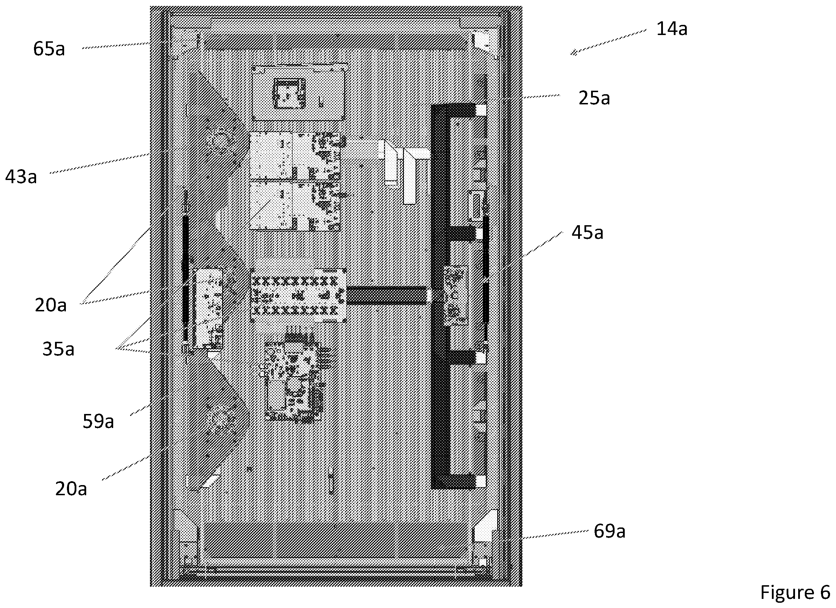

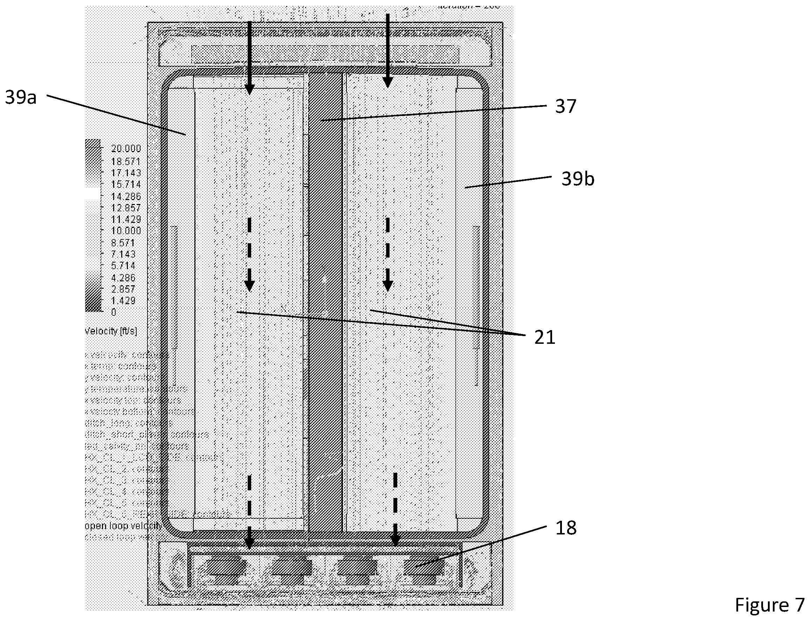

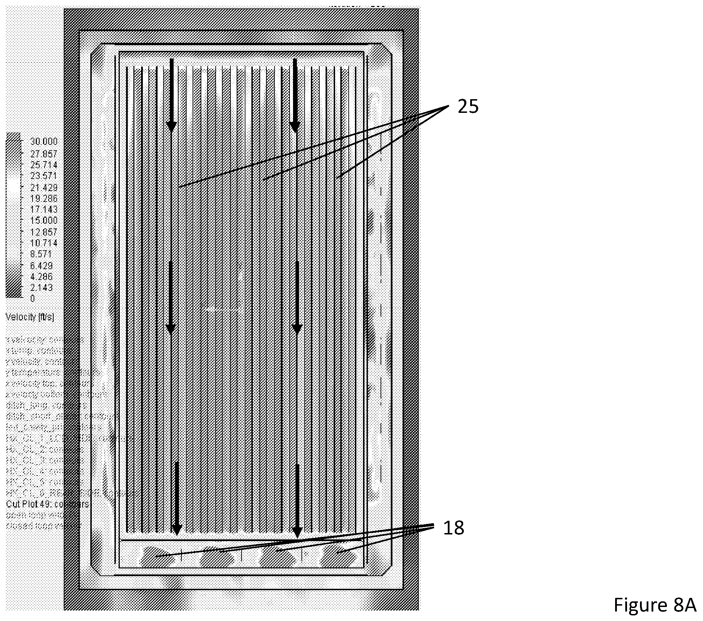

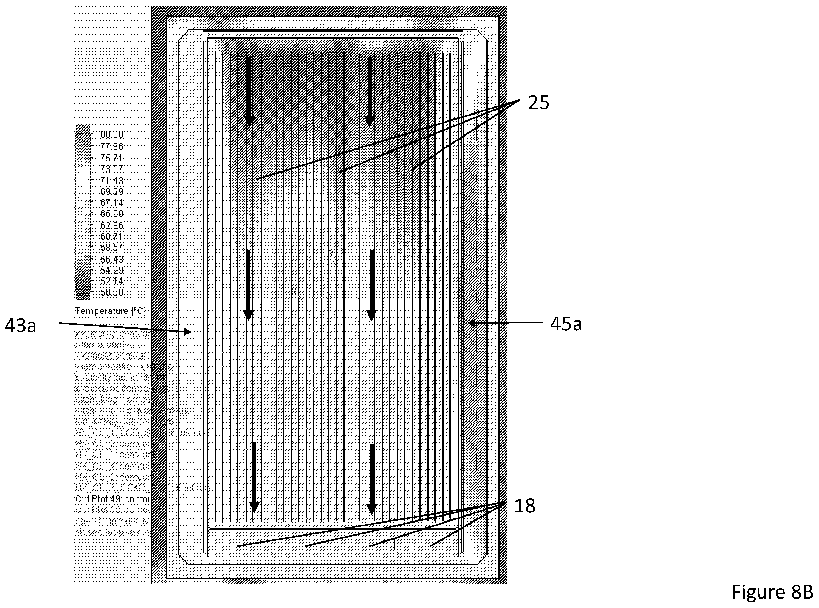

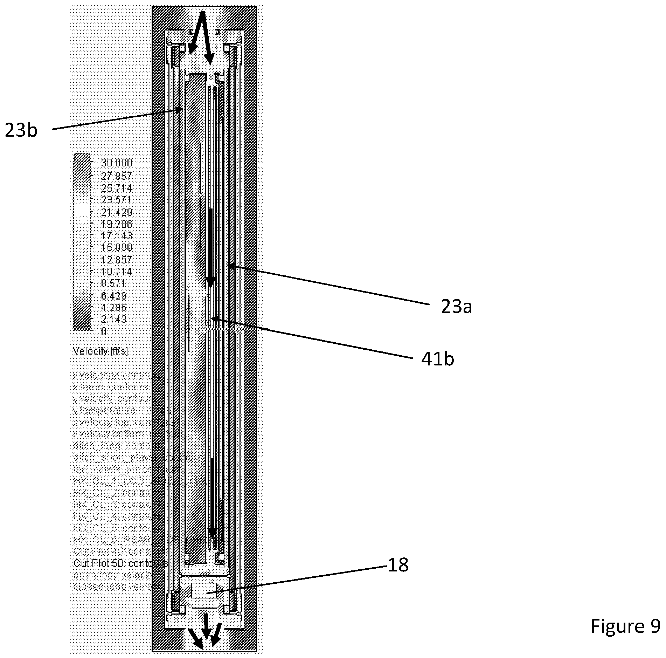

**FIGURE 2** through **FIGURE 9** illustrate exemplary internal structures of the units 10 and the various subassemblies 14 as well as airflows through the same. While two electronic display subassemblies 14a, 14b placed in a back-to-back arrangement are shown, any number of electronic display subassemblies 14 may be utilized in any arrangement at the structural framework 12. Similar, or the same, components used in conjunction with units 10 having multiple electronic display subassemblies 14 may use the same numbering with the addition of an "a", "b" and/or "1", "2", etc. (e.g., 14 to 14a, 14b, 31a1 to 31a2). The use of a base number may refer to all such components (e.g., 14 to 14a, 14b).

Each electronic display subassembly 14 comprises an illumination device 15. In exemplary embodiments, the illumination device 15 may comprise a number of lighting elements, such as LEDs, provided at a substrate, such as a printed circuit board and/or panel. Each electronic display subassembly 14 may comprise an electronic display layer 13. The electronic display layer 13 may comprise a layer of liquid crystals, such as for a liquid crystal type display, though any type or kind of electronic display may be utilized, including but not limited to, OLED, LCD, LED, plasma, cathode ray tube, rear projection, or the like. In exemplary embodiments, the illumination device 15 may be provided rearward of, and spaced apart from, the electronic display layer 13, such as to serve as a direct backlight. In other exemplary embodiments, the illumination device 15 may comprise one or more diffusive and/or transmissive layers and the substrate and/or lighting elements may be positioned about the edge of the electronic display layer 13 to provide edge lighting to the same. Alternatively, or additionally, one or more of the electronic display subassemblies 14 may comprise a cavity for a static poster instead of, or in addition to, to the electronic display layer 13 and/or a blank panel.

The illumination device 15 need not necessarily be located immediately behind the electronic display layer 13. For example, without limitation, one or more optical enhancement layers or films, diffusive elements, combinations thereof, or the like, may be interposed between the illumination device 15 and the electronic display layer 13, though such is not required. Furthermore, while the illumination device 15 may be spaced apart from the electronic display layer 13, such is not necessarily required.

The electronic display layer 13 and/or illumination device 15 of each subassembly 14 may be positioned rearward of a cover 11. The cover 11 may comprise one or more layers of a transparent or translucent material(s). In exemplary embodiments, each cover 11 may comprise two layers bonded with an optically clear adhesive, which may provide increased impact protection. One or more polarizers, anti-reflective materials, optical enhancement layers or films, combinations thereof, or the like may be disposed on some or all of various surfaces of the cover 11, such as but not limited to, in the form of various coatings, films, layers, combinations thereof, or the like. The cover 11 may form part of the electronic display subassembly 14 or may be separate therefrom. The cover 11 and the structural framework 12 may together substantially enclose the units 10, such as with external openings 16 exempted, when the subassemblies 14 are placed in a closed position. The cover 11 may be configured to move with the electronic display subassembly 14, may be configured for independent movement, and/or may be fixed to the structural framework 12. Each of the electronic display subassemblies 14 may be connected to the structural framework 12 in a hinged or otherwise movable manner, though such is not required.

The electronic display layer 13 need not necessarily be located immediately behind the cover 11. For example, without limitation, one or more optical layers may be interposed between the electronic display layer 13 and the cover 11, though such is not required. Furthermore, while the electronic display layer 13 may be spaced apart from the cover 11, though such is not necessarily required.

Multiple such electronic display subassemblies 14 may be provided at a given structural framework 12 for a given unit 10. For example, without limitation, two such subassemblies 14 may be mountable to opposing sides of the structural framework 12 so that the electronic display layers 13 face in substantially opposing directions, such as in a back-to-back arrangement. The electronic display subassemblies 14 may be of the same or different type and may comprise the same or different components. The electronic display subassemblies 14 and/or electronic display layers 13 may be provided in any arrangement such as portrait or landscape.

The external openings 16 may be fluidly connected to one or more subassembly airflow pathways 23. The subassembly airflow pathways 23 may extend through at least a portion of the units 10. A respective one of the subassembly airflow pathways 23a, 23b may extend through a respective one of the electronic display subassemblies 14a, 14b. The subassembly airflow pathways 23 may form part of an open loop airflow pathway, such that a flow of ambient air is provided through each one of the electronic display subassemblies 14. In exemplary embodiments, each of the subassembly airflow pathways 23 may share one or more common external openings for ingesting ambient air 16a. The ingested ambient air may be separated into flows through each of the subassembly airflow pathways 23 and may remain separated until exiting the unit 10, such as by way of separate external openings 16b in exemplary embodiments. For example, without limitation, the subassembly airflow pathways 23 may extend behind, and along at least a portion of, the illumination devices 15 for the electronic display layers 13. In this manner, cooling may be provided proximate to the illumination devices 15, which may be a significant heat generating component of the units 10.

Each of subassembly airflow pathways 23 may comprise one or more corrugated layers 25 in exemplary embodiments. The corrugated layers 25 may improve heat transfer from the illumination device 15 to ambient air in the subassembly airflow pathways 23 by increasing available surface area.

One or more closed loop airflow pathways may be provided within the units 10. In exemplary embodiments, such closed loop airflow pathways may include at least a front passageway 26a, 26b of each of the subassemblies 14a, 14b. The front passageway 26 may extend between the covers 11 and the electronic display layers 13 of the respective subassemblies 14. Such closed loop airflow pathways may alternatively, or additionally, comprise at least an illumination device passageway 27a, 27b of each of the subassemblies 14a, 14b. The illumination device passageways 27 may extend between each of the electronic display layers 13 and the illumination devices 15 of the respective electronic display subassemblies 14.

Various electronic components 35a, 35b for operating the subassemblies 14a, 14b, respectively, may be provided at rear panels 61a, 61b of the subassemblies 14a, 14b. In exemplary embodiments, the components 35 provided at a specific subassembly 14 may be utilized for operating that particular subassembly 14, though such is not necessarily required.

The rear panels 61a, 61b may be provided rearward of the illumination devices 15a, 15b and spaced apart therefrom to at least partially define the subassembly airflow pathways 23a, 23b and/or accommodate the corrugated layers 25a, 25b. Various components may be interposed between the rear panels 61 and the illumination devices 15, including but not necessarily limited to the corrugated layers 25, though such is not necessarily required.

The electronic components 35a, 35b may be located within a common passageway 21. The common passageway 21 may comprise a space or chamber located between the subassemblies 14 and/or the structural framework 12, and may be in fluid communication with the various subassemblies 14. The common passageway 21 may extend behind, and wholly or partially between, the electronic display subassemblies 14a, 14b. In exemplary embodiments, the common passageway 21 is in fluid communication with one or both of the front passageways 26 and the illumination device passageways 27 of the subassemblies 14. The common passageway 21 may be defined, at least in part, by said structural framework 12 and/or the subassemblies 14, such as by the rear panels 61.

The electronic components 35 may include, for example, without limitation, video players, power supplies, processors, electronic storage devices, controllers, sensors, combinations thereof, or the like. Any number, type, and/or kind of electronic components 35 may be utilized. The electronic components 35 may be configured to control other components of the unit 10. The electronic components 35a, 35b of a respective one of the subassemblies 14a, 14b may be configured to control components of the respective one of the subassemblies 14a, 14b, though such is not necessarily required.

The one or more closed loop airflow pathways may extend entirely within the units 10, such as within outer boundaries of the structural framework 12 and/or the electronic display subassemblies 14. The closed loop airflow pathway may comprise one or more of the common passageways 21, the front passageways 26, and/or the illumination device passageways 27.

A central septum 37 extends within the common passageway 21 and between the subassemblies 14 to divide the common passageway 21 into multiple portions 21a, 21b. For example, without limitation, a single central septum 37 may extend between first and second subassemblies 14a, 14b of a unit 10 to divide the common passage 21 into substantially two equal halves. In other exemplary embodiment, multiple central septa 37 may be utilized, such as where additional subassemblies 14 are utilized. The central septum 37 may extend along substantially the midline of the common passageway 21 and substantially perpendicular to the display layers 13a, 13b of the subassemblies 14a, 14b. The central septum 37 may comprise one or more angled surfaces as it extends between the subassemblies 14. This arrangement may improve aerodynamics for airflow and/or make room for equipment or other components further described herein. The central septum 37 in exemplary embodiments may be fixed to portions of the structural framework 12, but not the subassemblies 14. This may, for example without limitation, make each subassembly 14 substantially or fully identical to improve ease of manufacture and/or servicing. In other exemplary embodiments, the central septum 37 is attached to one of the subassemblies 14a, 14b.

The central septum 37 need not necessarily provide a 100% division between the portions of the common passageway 21a, 21b, though such may be the case in certain exemplary embodiments. Instead, it may be sufficient that that the central septum 37 provide a substantial separation between the portions 21. For example, such that at least 90% of airflow is prevented from crossover between the portions 21 and/or such that particulate above a predetermined size is prevented from crossover between the portions 21.

One or more side septa 39 may be provided within the common passageway 21. In exemplary embodiments, one of the side septa 39a, 39b may be provided within each of the common passageway portions 21a, 21b. The side septa 39 may be fixed to the structural assembly 12 in exemplary embodiments. Each of the side septa 39 may extend substantially parallel to the electronic display layers 13 of the subassemblies 14. Each side septa 39a, 39b may extend part of the way into the respective common passageway portions 21a, 21b. In this fashion, circulating gas within the units 10 may be forced to navigate about the side septa 39, which may increase dwell time within the common passageway portions 21 and/or increase surface area available for heat transfer.

One or more heat exchangers 41 may be provided between the subassemblies 14. In exemplary embodiments, one of the heat exchangers 41a, 41b may be provided within each of the common passageway portions 21a, 21b. The heat exchangers 41 may be affixed to the side septa 39 in exemplary embodiments. Each of the heat exchangers 41a, 41b may extend between a respective one of the rear panels 61a, 61b and a respective one of the side septa 39a, 39b and be located entirely within one of the common passageway portions 21a, 21b. In this manner, the circulating gas may be forced through portions of the heat exchangers 41 for added cooling. The heat exchangers 41 may accommodate ambient air and may be in fluid communication with the external openings 16. In other exemplary embodiments, the heat exchangers 41 may not be utilized. In exemplary embodiments, the heat exchanger(s) 41 may comprise multiple layers or portions which are fully or substantially separated such that the heat exchanger(s) 41 may simultaneously accommodate ambient air and circulating gas. The heat exchanger(s) 41 may be cross flow, counter flow, parallel flow, combinations thereof, or the like.

The units 10 may each comprise one or more movement imparting devices 31. In exemplary embodiments, the movement imparting devices 31 comprise gas springs. A first and second movement imparting device 31a1, 31a2, 31b1, 31b2 may be associated with each of the subassemblies 14a, 14b for moving the subassemblies 14a, 14b between open and closed positions.

One or more open loop fans 18 may be provided. In exemplary embodiments, a series of four open loop fans 18 are aligned about a lower portion of the unit 10. However, any number of open loop fans 18 may be provided in any arrangement. The open loop fans 18 may be of a same or different type. The open loop fans 18 may be configured to move ambient air through one or more open loop airflow pathways of the units 10 when activated. The open loop fans 18 may comprise axial fans, centrifugal fans, combinations thereof, or the like. Any number or type of fans 18 may be used at any location in the units 10, and may be provided in banks or sets. Each of the fans 18 may be operated and/or controlled together or separately.

Each of the subassemblies 14 may comprise subassembly intakes 65 in fluid communication with the external openings 16 for ingesting flows of ambient air into the respective subassembly airflow pathways 23a, 23b. Each of the subassemblies 14 may comprise a subassembly exhaust 69 in fluid communication with the external openings 16 for exhausting the ambient air from the units 10. In exemplary embodiments, the open loop fans 18 may be fluidly interposed between the subassembly exhausts 69 and the exhausts 16 for the unit 10. The open loop fans 18 may be configured to ingest ambient air into the units 10, exhaust ambient air from the units 10, and/or move ingested ambient air through the one or more subassembly airflow pathways 23 and/or heat exchangers 41 when activated. The same of different open loop fans 18 may be associated with each of the subassembly airflow pathways 23 and/or the heat exchangers 41. Separate open loop fans 18 may be used for each of the multiple electronic display subassemblies 14a, 14b and/or heat exchangers 41, or the open loop fans 18 may be common to some or all of the various electronic display subassemblies 14 and/or heat exchangers 41 of such units 10.

Each of the electronic display subassemblies 14a, 14b may comprise one or more closed loop fans 20, which may be of a same or different type. The closed loop fans 20 may be configured to move circulating gas through one or more closed loop airflow pathways of the units 10 when activated. The closed loop fans 20 may comprise axial fans, centrifugal fans, combinations thereof, or the like. Any number or type of fans 20 may be used at any location in the units 10, and may be provided in banks or sets. Each of the fans 20 may be operated and/or controlled together or separately.

The open loop airflow pathways may be partitioned and/or separated from the closed loop airflow pathways, though a complete (e.g., gas impermeable) separation or seal is not necessarily required. In exemplary embodiments, the separation may be sufficient to prevent solid and/or liquid particulate from passing therethrough and/or solid and/or liquid particulate above a given size from passing therethrough. For example, without limitation, such separation may be sufficient to meet certain ingress protection code (IPC) standards, such as, but not limited to, IP65, IP67, or the like. Each of the electronic display subassemblies 14a, 14b may comprise one or more partitions, gaskets, walls, panels, combinations thereof, or the like, which may provide separation between the ambient air in the open loop airflow pathways and the circulation gas in the closed loop airflow pathway(s). Alternatively, or additionally, one or more filters may be utilized between ambient air and/or circulating gas to separate between open and/or closed loop airflows.

Each subassembly 14a, 14b may comprise a number of the closed loop fans 20a, 20b, respectively. A housing 59a, 59b may be provided about some of all of the closed loop fans 20a, 20b, respectively, of a given one of the subassemblies 14a, 14b. The housings or fan tray 59 of a given one of the subassemblies 14 may be configured to accommodate all of the closed loop fans 20 the given one of the subassemblies 14. However, in other exemplary embodiments, each individual fans 20 or groups of the individual fans 20 may comprise separate housings 59. The housing 59 may be configured to permit ingestion of the circulating gas from the common passageway portions 21a, 21b and direct the ingested circulating gas in an appropriate direction, such through entrances 43 into the front passageways 26 and/or the illumination device passageway 27 of the electronic display subassembly 14, and/or out exits 45 for the same. The housings 59 may be configured to provide a relatively laminar flow within the front passageway 26 and/or the illumination device passageway 27. The fans 20 may be positioned within the housings 59 to accomplish the same. For example, without limitation, an intake for the fans 20 may be fluidly adjacent to the common passageway portions 21 and an exhaust for the fans 20 may be fluidly adjacent to the front passageway 26 and/or the illumination device passageway 27.

Each of the closed loop fans 20 may be provided proximate to the entrances 43 into one or both of the front passageway 26 and the illumination device passageway 27 for generating the flows through the front passageway 26 and the illumination device passageway 27, respectively, such as by pushing the circulating gas through the front passageway 26 and the illumination device passageway 27 when the fan(s) 20 are activated. An exhaust, relatively high-pressure side of the closed loop fans 20 may be positioned fluidly adjacent to the front passageway 26 and/or the illumination device passageway 27, so that a relatively high, positive pressure (e.g., greater than pressure of ambient air outside of the units 10) is generated for circulating gas within the front passageway 26 and the illumination device passageway 27, though such is not necessarily required. This may reduce or eliminate bowing of the electronic display layer 13 to improve optics. Alternatively, or additionally, this may reduce or eliminate tensile mechanical stresses on the electronic display layer 13 to reduce or eliminate cell breach.

In exemplary embodiments, the front passageway 26 and/or the illumination device passageway 27 may be configured to create and maintain a pressure differential between the flows of the circulating gas in the front passageway 26 and/or the illumination device passageway 27 sufficient to generate net forces at the electronic display layers 13 which reduce or eliminate bowing of the electronic display layers 13. In exemplary embodiments, the pressure of the flow in the front passageway 26 may be maintained at a higher level than the flow in the illumination device passageway 27, resulting in rearward forces against the electronic display layer 13 to reduce or eliminate outward bowing. Such pressure differentials may be generated using features including, but not limited to, those shown and/or described in US Pat. No. 10,398,066 issued August 27, 2019, the disclosures of which are hereby incorporated by reference as if fully restated herein.

The housing 59 for the closed loop fans 20 may comprise a generally curved shaped. A rear wall of the housing 59 may define one or more peaks to accommodate respective ones of the fans 20 and a valley between adjacent ones of the fans 20. Each housing 59 may be configured to accommodate any number of fans 20. A single or multiple closed loop fan 20 and/or housings 59 may be used with each side assembly 14. Because the closed loop fans 20, particularly when provided as centrifugal fans, may be configured to exhaust fluid in a generally pinwheel pattern (e.g., outward from a center), the curved shape of the rear wall may encourage relatively laminar flow into the front passageway 26 and/or illumination device passageway 27. The fans 20 may be spaced from the entrance 43 to the front passageway 26 and/or illumination device passageway 27 and a leading edge of the housings 59 may extend at an angle, though such is not required, to encourage flow into the front passageway 26 and/or illumination device passageway 27. The rear wall may define a generally sinusoidal shape curve by way of non-limiting example. Alternatively, or additionally, the rear wall may define a generally wave or boomerang shape. The shape of the rear wall need not be perfectly curved or smooth and may include one or more portions of which are planar.

When positioned on opposing sides of the structural framework 12, the closed loop fans 20a, 20b may be located on opposing sides of the unit 10 from one another. This may be particularly true where the electronic display subassemblies 14a, 14b are the same, or substantially the same. This arrangement may cause circulating gas exiting the subassemblies 14, such as at exits 45a, 45b for the front passageways 26 and/or illumination device passageways 27, to take a sinuous route through the units 10. In exemplary embodiments, circulating gas exiting the front passageways 26a and/or illumination device passageways 27a of a first one of the subassemblies 14a at an exit area 45a may be forced to travel through the first heat exchanger 41a in the second portion of the common passageway 21b, at least in part due to the first side septum 39a, and about the various electronic components 35b of the second subassembly 14b before reaching the entrance 43b of the second subassembly 14b. The circulating gas may then flow through either or both of the front passageway 26b and/or illumination device passageway 27b of the second side assembly 14b before exiting at the exit 45b and into the second heat exchanger 21b within the first common passageway portion 21a and about the various electronic components 35a of the first subassembly 14a before reaching the entrance 43a of the first subassembly 14a. The circulating gas may then flow through either or both of the front passageway 26a and/or illumination device passageway 27a of the first side assembly 14a and continue recirculating through the unit 10. The center septum 37 may prevent some or any cross over of the circulating gas between the common passageway portions 21a, 21b. This may force circulating gas to take a sinuous path between the first and second subassemblies 14a, 14b, increasing surface area and time for heat transfer.

A method for thermally managing the units 10 may include moving circulating gas through a closed loop airflow pathway. The closed loop airflow pathway may include one or more of: the front passageways 26, the illumination device passageways 27, the common passageway(s) 21, and the heat exchanger(s) 41. More specifically, a flow of circulating gas may begin in the front passageway 26 of a first one of the subassemblies 14a, be joined with another flow of the circulating gas traveling through the illumination device passageways 27a of the first one of the subassemblies 14a when passing through the exit 45a of the first one of the subassemblies 14a and into a second portion 21b of the common passageway 21. The combined flow may be forced through the first heat exchanger 41a by the first side septum 39a. The combined flow may be forced through the entrance 43b of the second one of the subassemblies 14b by the central septum 37, the housing 59b, and/or the closed loop fan 20b. A portion of this combined flow may first be forced about or proximate to the electronic components 35b. The combined flow may split and a portion may travel through the front passageway 26b of the second one of the subassemblies 14b and the illumination device passageway 27b of the second one of the subassemblies 14b. The flow may be recombined when traveling through the exit 45b of the second one of the subassemblies 14b. The combined flow may be forced to travel through the second heat exchanger 41b by the second side septum 39b. The combined flow may be forced through the entrance 43a of the first one of the subassemblies 14a by the central septum 37, the housing 59a, and/or the closed loop fan 20a. A portion of this combined flow may first be forced about or proximate to the electronic components 35a. The circulating gas may be repeatedly recirculated in this fashion. While separation and joinder of flows is discussed, this does not mean that the flows necessarily have the same velocity, pressure, mass flow rate, combinations thereof, or the like. For example, the same portion of the flow may not always or necessarily be rejoined, separated, or the like. Movement of the circulating gas within the closed loop airflow pathway(s) may be accomplished by activation of the closed loop fans 20.

The method may alternatively or additionally include moving ambient air through one or more open loop airflow pathways within the units 10. The open loop airflow pathways may comprise one or more of: the external openings 16, the subassembly airflow pathways 23, and the heat exchangers 41. In exemplary embodiments, without limitation, ambient air may be ingested by way of external openings 16 at an upper portion of the unit 10 and separated into flows through the subassembly airflow pathways 23a of the first subassembly 14a, the first heat exchanger 41a, the second heat exchanger 41b, and the second subassembly airflow pathways 23b. Movement of the ambient air within the open loop airflow pathway(s) may be accomplished by activation of some or all of the open loop fans 18.

In other exemplary embodiments, the central septum 37 may be omitted. The side septa 39 may provide partitions or baffles for the circulating gas in the rear passageway 21. Such embodiments may include or omit the heat exchangers 41.

The closed loop fans 20 and the open loop fans 18 may be operated at the same or different times. The ambient air may be moved through the open loop airflow pathway at the same or different time as the circulating gas is moved through the closed loop airflow pathway. Some or all of the closed loop fans 20 and the open loop fans 18 may be operated at a given time.

While the flow of circulating gas shown and/or described herein is primarily referenced with regard to a generally clockwise travel, a generally counter-clockwise travel may alternatively be utilized. This may be accomplished using the same structure, such as but not limited to, location of the entrances 43, exits 45, closed loop fans 20, and/or heat exchangers 41, and the closed loop fans 20 may be instead operated in reverse or installed in an opposing orientation. Alternatively, a generally counter-clockwise directional flow may be accomplished with a different structure, such as by reversing the location of the entrances 43, exits 45, closed loop fans 20, and/or heat exchangers 41.

While the flow of ambient air shown and/or described herein is primarily referenced with regard to a top-to-bottom flow arrangement, a generally bottom-to-top flow may alternatively be utilized. This may be accomplished using the same structure, such as but not limited to, location of the open loop fans 18 may be instead operated in reverse or installed in an opposing orientation. Alternatively, a generally bottom-to-top flow may be accomplished with a different structure, such as by placing the open loop fans 18 proximate to an upper portion of the units 10.

Certain operations described herein may be performed by one or more electronic devices. Each electronic device may comprise one or more processors, electronic storage devices, executable software instructions, combinations thereof, and the like configured to perform the operations described herein. The electronic devices may be general purpose computers or specialized computing devices. The electronic devices may comprise personal computers, smartphones, tablets, databases, servers, or the like. The electronic connections and transmissions described herein may be accomplished by wired or wireless means. The computerized hardware, software, components, systems, steps, methods, and/or processes described herein may serve to improve the speed of the computerized hardware, software, systems, steps, methods, and/or processes described herein.

## Claims

1. A display assembly (10) with divided interior space, said display assembly comprising:
a structural framework (12);
a first and second electronic display subassembly (14), each attached to said structural framework (12) and comprising:
a cover (11);
an electronic display layer (13) located rearward of said cover (11);
an illumination device (15) for providing illumination to said electronic display layer when powered; and
a passageway (26) for circulating gas;
a common passageway (21) for the circulating gas located, at least in part, between the first and second electronic display subassembly (14) and in fluid communication with the passageways (26) of the first and second electronic display subassemblies (14) to form at least part of a closed loop airflow pathway for the gas; and
a central septum (37) comprising one or more angled surfaces extending within the common passageway (21) to prevent the gas from directly traveling between a first portion and a second portion of the common passageway (21), wherein said first and second portions are defined, at least in part, by the central septum (37), and where each of the first and second portion are fluidly connected with the passageways (26) of the first and second electronic display subassemblies (14).

2. The display assembly of claim 1 wherein:
an entrance (43a) to said passageway (26a) of said first electronic display subassembly (14a) is fluidly adjacent to said first portion of said common passageway (21);
an exit (45b) to said passageway (26b) of said second electronic display subassembly (14b) is fluidly adjacent to said first portion of said common passageway (21);
an entrance (43b) to said passageway (26b) of said second electronic display subassembly (14b) is fluidly adjacent to said second portion of said common passageway (21); and
an exit (45a) to said passageway (26a) of said first electronic display subassembly (14a) is fluidly adjacent to said second portion of said common passageway (21).

3. The display assembly of any one of claims 1-2 further comprising:
a first side septum (39a) extending within the first portion of said common passageway (21); and
a second side septum (39b) extending within the second portion of said common passageway (21).

4. The display assembly of any one of claims 1-3 wherein:
said passageway (26a) of said first electronic display subassembly (14a) is located between said cover (11) and said electronic display layer (13) of said first electronic display subassembly (14a); and
said passageway (26b) of said second electronic display subassembly (14b) is located between said cover (11) and said electronic display layer (13) of said second electronic display subassembly (14b).

5. The display assembly of any one of claims 1-4 wherein:
said illumination devices (15) of said first and second electronic display subassemblies (14) are each configured to provide direct backlighting to the electronic display layer (13) of a respective one of said first and second electronic display subassemblies (14) when activated;
each of said first and second electronic display subassemblies (14) comprise an additional passageway (27) located between said electronic display layer (13) and said illumination device (15) of the respective one of said first and second electronic display subassemblies (14), where each of said additional passageways (27) are in fluid communication with said common passageway (21); and
at least said common passageway (21), said passageways (26) of said first and second electronic display subassemblies (14), and said additional passageways (27) of said first and second electronic display subassemblies (14) form at least part of the closed, continuous airflow pathway for circulating gas.

6. The display assembly of any one of claims 1-5 wherein:
each of said first and second electronic display subassemblies (14) comprise an open passageway for ambient air.

7. The display assembly of any one of claims 1-6 further comprising:
a first heat exchanger (41a) located within said first portion of said common passageway (21); and
a second heat exchanger (41b) located within said second portion of said common passageway (21).

8. The display assembly of any one of claims 1-7 further comprising:
a first set of electronic components (35a) located within said first portion of said common passageway (21) and electrically connected to said first electronic display subassembly (14a); and
a second set of electronic components (35b) located within said second portion of said common passageway (21) and electrically connected to said second electronic display subassembly (14b).

9. The display assembly of any one of claims 1-8 wherein:
each of said first and second electronic display subassemblies (14) are moveably mounted to said structural framework (12).

10. The display assembly of any one of claims 1-9 wherein:
each of said first and second electronic display subassemblies (14) comprise a plurality of centrifugal type fans (20) located within a common housing (59) for moving circulating gas through said display assembly (10) when activated.

11. The display assembly of claim 10 wherein:
the common housing (59) comprises a generally curved shape which extends to a peak at a first side of each of said plurality of centrifugal type fans (20) and a valley between each of said plurality of centrifugal type fans (20), where said valley is located at a second side of each of said plurality of centrifugal type fans (20).

12. The display assembly of any one of claims 10-11 further comprising:
a plurality of centrifugal type fans (18) secured to said structural framework (12) for moving ambient air through said display assembly (10) when activated;
an intake (16a) located at an upper portion of said structural framework (12);
a first exhaust (16b) located at a first side of said structural framework (12) below said first electronic display subassembly (14a); and
a second exhaust (16b) located at a second side of said structural framework (12) below said second electronic display subassembly (14b).

13. The display assembly of any one of claims 1-12 wherein:
the central septum (37) gasously partitions the common passageway (21).

14. The display assembly of any one of claims 1-13 wherein:
at least a portion of the one or more angled surfaces of said central septum (37) extend at a non-perpendicular angle relative to rear surfaces of said first and second electronic display subassembly (14).

## Patentansprüche

1. Anzeigeanordnung (10) mit unterteiltem Innenraum, wobei die Anzeigeanordnung Folgendes umfasst:
einen strukturellen Rahmen (12);
eine erste und zweite Teilanordnung einer elektronischen Anzeige (14), die jeweils an dem strukturellen Rahmen (12) befestigt sind und Folgendes umfassen:
eine Abdeckung (11);
eine Schicht der elektronischen Anzeige (13), die sich hinter der Abdeckung (11) befindet;
eine Beleuchtungsvorrichtung (15) zum Bereitstellen einer Beleuchtung für die Schicht der elektronischen Anzeige, wenn mit Strom versorgt; und
einen Durchgang (26) für zirkulierendes Gas;
einen gemeinsamen Durchgang (21) für das zirkulierende Gas, der sich mindestens teilweise zwischen der ersten und zweiten Teilanordnung der elektronischen Anzeige (14) befindet und mit den Durchgängen (26) der ersten und zweiten Teilanordnung der elektronischen Anzeige (14) in Fluidkommunikation steht, um mindestens einen Teil eines geschlossen Umlauf-Luftströmungswegs für das Gas zu bilden; und
eine zentrale Trennwand (37), umfassend eine oder mehrere abgewinkelte Oberflächen, die sich innerhalb des gemeinsamen Durchgangs (21) erstrecken, um zu verhindern, dass das Gas direkt zwischen einem ersten Abschnitt und einem zweiten Abschnitt des gemeinsamen Durchgangs (21) übertritt, wobei der erste und zweite Abschnitt mindestens teilweise durch die zentrale Trennwand (37) definiert sind, und wobei der erste und zweite Abschnitt jeweils fluidisch mit den Durchgängen (26) der ersten und zweiten Teilanordnung der elektronischen Anzeige (14) verbunden sind.

2. Anzeigeanordnung nach Anspruch 1, wobei:
ein Eingang (43a) zu dem Durchgang (26a) der ersten Teilanordnung der elektronischen Anzeige (14a) fluidisch zu dem ersten Abschnitt des gemeinsamen Durchgangs (21) benachbart ist;
ein Ausgang (45b) zu dem Durchgang (26b) der zweiten Teilanordnung der elektronischen Anzeige (14b) fluidisch zu dem ersten Abschnitt des gemeinsamen Durchgangs (21) benachbart ist;
ein Eingang (43b) zu dem Durchgang (26b) der zweiten Teilanordnung der elektronischen Anzeige (14b) fluidisch zu dem zweiten Abschnitt des gemeinsamen Durchgangs (21) benachbart ist; und
ein Ausgang (45a) zu dem Durchgang (26a) der ersten Teilanordnung der elektronischen Anzeige (14a) fluidisch zu dem zweiten Abschnitt des gemeinsamen Durchgangs (21) benachbart ist.

3. Anzeigeanordnung nach einem der Ansprüche 1-2, ferner umfassend:
eine erste Seitentrennwand (39a), die sich innerhalb des ersten Abschnitts des gemeinsamen Durchgangs (21) erstreckt; und
eine zweite Seitentrennwand (39b), die sich innerhalb des zweiten Abschnitts des gemeinsamen Durchgangs (21) erstreckt.

4. Anzeigeanordnung nach einem der Ansprüche 1-3, wobei:
sich der Durchgang (26a) der ersten Teilanordnung der elektronischen Anzeige (14a) zwischen der Abdeckung (11) und der Schicht der elektronischen Anzeige (13) der ersten Teilanordnung der elektronischen Anzeige (14a) befindet; und
sich der Durchgang (26b) der zweiten Teilanordnung der elektronischen Anzeige (14b) zwischen der Abdeckung (11) und der Schicht der elektronischen Anzeige (13) der zweiten Teilanordnung der elektronischen Anzeige (14b) befindet.

5. Anzeigeanordnung nach einem der Ansprüche 1-4, wobei:
die Beleuchtungsvorrichtungen (15) der ersten und zweiten Teilanordnung der elektronischen Anzeige (14) jeweils ausgelegt sind, um der Schicht der elektronischen Anzeige (13) einer jeweiligen einen von der ersten und zweiten Teilanordnung der elektronischen Anzeige (14), wenn aktiviert, eine direkte Hintergrundbeleuchtung bereitzustellen;
die erste und zweite Teilanordnung der elektronischen Anzeige (14) jeweils einen zusätzlichen Durchgang (27) umfassen, der sich zwischen der Schicht der elektronischen Anzeige (13) und
der Beleuchtungsvorrichtung (15) der jeweiligen einen von der ersten und zweiten Teilanordnung der elektronischen Anzeige (14) befindet, wobei die zusätzlichen Durchgänge (27) jeweils in Fluidkommunikation mit dem gemeinsamen Durchgang (21) sind; und
mindestens der gemeinsame Durchgang (21), die Durchgänge (26) der ersten und zweiten Teilanordnung der elektronischen Anzeige (14) und die zusätzlichen Durchgänge (27) der ersten und zweiten Teilanordnung der elektronischen Anzeige (14) mindestens einen Teil des geschlossenen, kontinuierlichen Luftströmungswegs für zirkulierendes Gas bilden.

6. Anzeigeanordnung nach einem der Ansprüche 1-5, wobei:
die erste und zweite Teilanordnung der elektronischen Anzeige (14) jeweils einen offenen Durchgang für Umgebungsluft umfassen.

7. Anzeigeanordnung nach einem der Ansprüche 1-6, ferner umfassend:
einen ersten Wärmetauscher (41a), der sich innerhalb des ersten Abschnitts des gemeinsamen Durchgangs (21) befindet; und
einen zweiten Wärmetauscher (41b), der sich innerhalb des zweiten Abschnitts des gemeinsamen Durchgangs (21) befindet.

8. Anzeigeanordnung nach einem der Ansprüche 1-7, ferner umfassend:
einen ersten Satz elektronischer Komponenten (35a), die sich innerhalb des ersten Abschnitts des gemeinsamen Durchgangs (21) befinden und elektrisch mit der ersten Teilanordnung der elektronischen Anzeige (14a) verbunden sind; und
einen zweiten Satz elektronischer Komponenten (35b), die sich innerhalb des zweiten Abschnitts des gemeinsamen Durchgangs (21) befinden und elektrisch mit der zweiten Teilanordnung der elektronischen Anzeige (14b) verbunden sind.

9. Anzeigeanordnung nach einem der Ansprüche 1-8, wobei:
die erste und zweite Teilanordnung der elektronischen Anzeige (14) jeweils bewegbar an dem strukturellen Rahmen (12) montiert sind.

10. Anzeigeanordnung nach einem der Ansprüche 1-9, wobei:
die erste und zweite Teilanordnung der elektronischen Anzeige (14) jeweils eine Vielzahl von Lüftern vom Radialtyp (20) umfassen, die sich innerhalb eines gemeinsamen Gehäuses (59) zum Bewegen von zirkulierendem Gas durch die Anzeigeanordnung (10), wenn aktiviert, befinden.

11. Anzeigeanordnung nach Anspruch 10, wobei:
das gemeinsame Gehäuse (59) eine im Allgemeinen gekrümmte Form umfasst, die sich zu einer Spitze an einer ersten Seite jedes der Vielzahl von Lüftern vom Radialtyp (20) und einer Vertiefung zwischen jedem der Vielzahl von Lüftern vom Radialtyp (20) erstreckt, wobei sich die Vertiefung an einer zweiten Seite jedes der Vielzahl von Lüftern vom Radialtyp (20) befindet.

12. Anzeigeanordnung nach einem der Ansprüche 10-11, ferner umfassend:
eine Vielzahl von Lüftern vom Radialtyp (18), die an dem strukturellen Rahmen (12) zum Bewegen von Umgebungsluft durch die Anzeigeanordnung (10), wenn aktiviert, gesichert sind;
einen Einlass (16a), der sich an einem oberen Abschnitt des strukturellen Rahmens (12) befindet;
einen ersten Auslass (16b), der sich an einer ersten Seite des strukturellen Rahmens (12) unterhalb der ersten Teilanordnung der elektronischen Anzeige (14a) befindet; und
einen zweiten Auslass (16b), der sich an einer zweiten Seite des strukturellen Rahmens (12) unterhalb der zweiten Teilanordnung der elektronischen Anzeige (14b) befindet.

13. Anzeigeanordnung nach einem der Ansprüche 1-12, wobei:
die zentrale Trennwand (37) den gemeinsamen Durchgang (21) gasführend unterteilt.

14. Anzeigeanordnung nach einem der Ansprüche 1-13, wobei:
sich mindestens ein Abschnitt der einen oder mehreren abgewinkelten Oberflächen der zentralen Trennwand (37) an einem nicht senkrechten Winkel relativ zu hinteren Oberflächen der ersten und zweiten Teilanordnung der elektronischen Anzeige (14) erstreckt.

## Revendications

1. Ensemble d'affichage (10) à espace intérieur divisé, ledit ensemble d'affichage comprenant :
un cadre structurel (12) ;
un premier et un second sous-ensemble d'affichage électronique (14), chacun fixé audit cadre structurel (12) et comprenant :
un couvercle (11) ;
une couche d'affichage électronique (13) située à l'arrière dudit couvercle (11) ;
un dispositif d'éclairage (15) destiné à assurer l'éclairage de ladite couche d'affichage électronique lorsqu'il est alimenté ; et
un passage (26) destiné à faire circuler du gaz ;
un passage commun (21) pour le gaz en circulation situé, au moins en partie, entre le premier et le second sous-ensemble d'affichage électronique (14) et en communication fluidique avec les passages (26) des premier et second sous-ensembles d'affichage électronique (14) afin de former au moins une partie d'un trajet d'écoulement d'air en boucle fermée pour le gaz ; et
un septum central (37) comprenant une ou plusieurs surfaces inclinées s'étendant dans le passage commun (21) pour empêcher le gaz de circuler directement entre une première partie et une seconde partie du passage commun (21), dans lequel lesdites première et seconde parties sont définies, au moins en partie, par le septum central (37), et chacune des première et seconde parties étant connectée de manière fluidique aux passages (26) des premier et second sous-ensembles d'affichage électronique (14).

2. Ensemble d'affichage selon la revendication 1, dans lequel :
une entrée (43a) dudit passage (26a) dudit premier sous-ensemble d'affichage électronique (14a) est adjacente de manière fluidique à ladite première partie dudit passage commun (21) ;
une sortie (45b) dudit passage (26b) dudit second sous-ensemble d'affichage électronique (14b) est adjacente de manière fluidique à ladite première partie dudit passage commun (21) ;
une entrée (43b) dudit passage (26b) dudit second sous-ensemble d'affichage électronique (14b) est adjacente de manière fluidique à ladite seconde partie dudit passage commun (21) ; et
une sortie (45a) dudit passage (26a) dudit premier sous-ensemble d'affichage électronique (14a) est adjacente de manière fluidique à ladite seconde partie dudit passage commun (21).

3. Ensemble d'affichage selon l'une quelconque des revendications 1 et 2, comprenant en outre :
un premier septum latéral (39a) s'étendant dans la première partie dudit passage commun (21) ; et
un second septum latéral (39b) s'étendant dans la seconde partie dudit passage commun (21).

4. Ensemble d'affichage selon l'une quelconque des revendications 1 à 3, dans lequel :
ledit passage (26a) dudit premier sous-ensemble d'affichage électronique (14a) est situé entre ledit couvercle (11) et ladite couche d'affichage électronique (13) dudit premier sous-ensemble d'affichage électronique (14a) ; et
ledit passage (26b) dudit second sous-ensemble d'affichage électronique (14b) est situé entre ledit couvercle (11) et ladite couche d'affichage électronique (13) dudit second sous-ensemble d'affichage électronique (14b).

5. Ensemble d'affichage selon l'une quelconque des revendications 1 à 4, dans lequel :
lesdits dispositifs d'éclairage (15) desdits premier et second sous-ensembles d'affichage électronique (14) sont chacun configurés pour fournir un rétroéclairage direct à la couche d'affichage électronique (13) d'un sous-ensemble respectif desdits premier et second sous-ensembles d'affichage électronique (14) lorsqu'ils sont activés ;
chacun desdits premier et second sous-ensembles d'affichage électronique (14) comprend un passage supplémentaire (27) situé entre ladite couche d'affichage électronique (13) et ledit dispositif d'éclairage (15) du sous-ensemble respectif desdits premier et second sous-ensembles d'affichage électronique (14), chacun desdits passages supplémentaires (27) étant en communication fluidique avec ledit passage commun (21) ; et
au moins ledit passage commun (21), lesdits passages (26) desdits premier et second sous-ensembles d'affichage électronique (14), et lesdits passages supplémentaires (27) desdits premier et second sous-ensembles d'affichage électronique (14) forment au moins une partie du trajet d'écoulement d'air fermé et continu pour la circulation du gaz.

6. Ensemble d'affichage selon l'une quelconque des revendications 1 à 5, dans lequel :
chacun desdits premier et second sous-ensembles d'affichage électronique (14) comprend un passage ouvert pour l'air ambiant.

7. Ensemble d'affichage selon l'une quelconque des revendications 1 à 6, comprenant en outre :
un premier échangeur de chaleur (41a) situé dans ladite première partie dudit passage commun (21) ; et
un second échangeur de chaleur (41b) situé dans ladite seconde partie dudit passage commun (21).

8. Ensemble d'affichage selon l'une quelconque des revendications 1 à 7, comprenant en outre :
un premier ensemble de composants électroniques (35a) situé dans ladite première partie dudit passage commun (21) et connecté électriquement audit premier sous-ensemble d'affichage électronique (14a) ; et
un second ensemble de composants électroniques (35b) situé dans ladite seconde partie dudit passage commun (21) et électriquement connecté audit second sous-ensemble d'affichage électronique (14b).

9. Ensemble d'affichage selon l'une quelconque des revendications 1 à 8, dans lequel :
chacun desdits premier et second sous-ensembles d'affichage électronique (14) est monté de manière mobile sur ledit cadre structurel (12).

10. Ensemble d'affichage selon l'une quelconque des revendications 1 à 9, dans lequel :
chacun desdits premier et second sous-ensembles d'affichage électronique (14) comprend une pluralité de ventilateurs de type centrifuge (20) situés dans un boîtier commun (59) destinés à déplacer le gaz en circulation à travers ledit ensemble d'affichage (10) lorsqu'ils sont activés.

11. Ensemble d'affichage selon la revendication 10, dans lequel :
le boîtier commun (59) comprend une forme généralement incurvée qui s'étend jusqu'à un pic sur un premier côté de chacun de ladite pluralité de ventilateurs de type centrifuge (20) et une vallée entre chacun de ladite pluralité de ventilateurs de type centrifuge (20), ladite vallée étant située sur un second côté de chacun de ladite pluralité de ventilateurs de type centrifuge (20).

12. Ensemble d'affichage selon l'une quelconque des revendications 10 et 11, comprenant en outre :
une pluralité de ventilateurs de type centrifuge (18) fixés audit cadre structurel (12) destinés à déplacer l'air ambiant à travers ledit ensemble d'affichage (10) lorsqu'ils sont activés ;
une prise d'air (16a) située au niveau de la partie supérieure dudit cadre structurel (12) ;
un premier échappement (16b) situé sur un premier côté dudit cadre structurel (12) sous ledit premier sous-ensemble d'affichage électronique (14a) ; et
un second échappement (16b) situé sur un second côté dudit cadre structurel (12) sous ledit second sous-ensemble d'affichage électronique (14b).

13. Ensemble d'affichage selon l'une quelconque des revendications 1 à 12, dans lequel :
le septum central (37) divise gazement le passage commun (21).

14. Ensemble d'affichage selon l'une quelconque des revendications 1 à 13, dans lequel :
au moins une partie des une ou plusieurs surfaces inclinées dudit septum central (37) s'étendent selon un angle non perpendiculaire par rapport aux surfaces arrière desdits premier et second sous-ensembles d'affichage électronique (14).
